# DEMANDE DE BREVET EUROPEEN

(11) **EP 3 598 506 A1**
(43) Date de publication de la demande: **22.01.2020**
(21) Numéro de dépôt: 19186516.1
(22) Date de dépôt: 16.07.2019
(51) Int. Cl.: H01L 31/042, H01L 31/05

(54) **ASSEMBLAGE AMELIORE DE CELLULES SOLAIRES A CONTACTS EN FACE ARRIERE**

(30) Priorité: 18.07.2018 FR 1856657
(71) Demandeur: Commissariat à l'énergie atomique et aux énergies alternatives, 75015 Paris (FR)
(72) Inventeur: LEFILLASTRE, Paul, 38054 GRENOBLE CEDEX 09 (FR); GERRITSEN, Eric, 38054 GRENOBLE CEDEX 09 (FR)
(74) Mandataire: Brevalex

(57) **Abrégé**

Module photovoltaïque à cellules solaires à contacts en face arrière, en particulier de type IBC, comprenant une première cellule (10₁) assemblée à une deuxième cellule (10₂), ladite deuxième cellule étant agencée de sorte qu'une zone périphérique de la face arrière de la deuxième cellule chevauche une région périphérique de la face avant de la première cellule, un élément de connexion reliant un élément conducteur de la région périphérique à un autre élément conducteur située sur une zone périphérique de la face arrière de la première cellule (figure 6A).

## Description

### DOMAINE TECHNIQUE

La présente demande concerne le domaine des cellules photovoltaïques (PV), également appelées cellules solaires et plus particulièrement celui des cellules à contacts en face arrière RCC (pour « Rear Contact Cells »).

La présente invention a trait à un assemblage particulier de cellules solaires à contact en face arrière, à un procédé de réalisation d'un tel assemblage ainsi qu'à un module photovoltaïque comportant un tel assemblage.

### ÉTAT DE LA TECHNIQUE ANTÉRIEURE

Une cellule solaire est généralement formée à partir d'un substrat semiconducteur comportant des régions dopées ayant des types de conductivité opposés et réalisant au moins une jonction. Des contacts électriques, typiquement sous forme d'électrodes métalliques disposées en contact avec les régions dopées sont prévus en surface de la cellule.

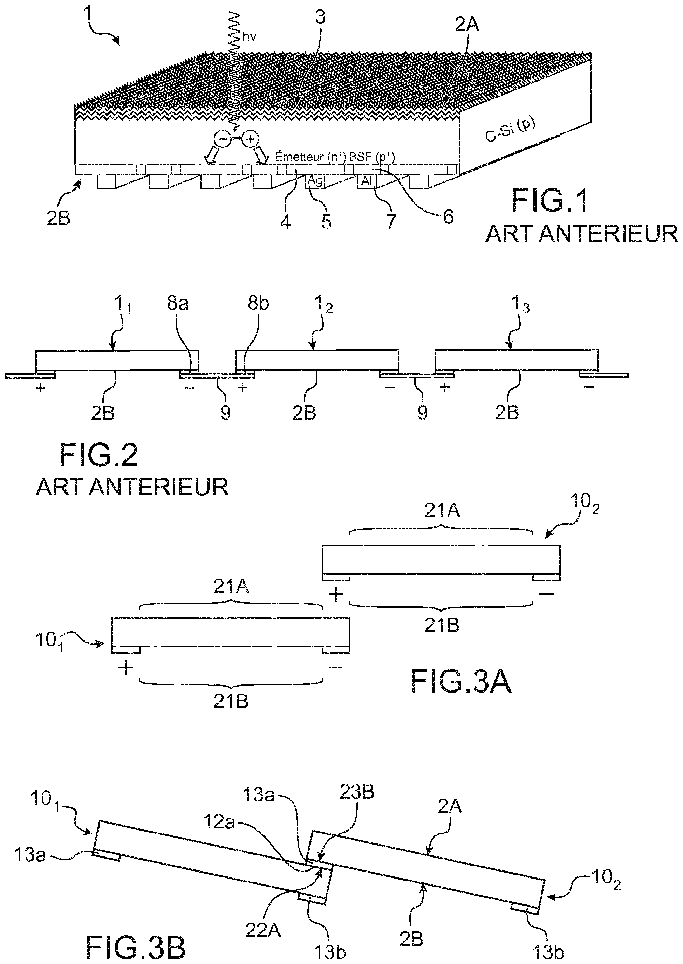

Pour augmenter l'efficacité d'une cellule solaire, un agencement particulier « à contact en face arrière » RCC (pour « Rear Contact Cells ») est apparu. Il consiste, comme dans l'exemple de cellule 1 illustré sur la figure 1A, à répartir les contacts 5, 7 aux régions dopées, 4, 6 de type N et P sur la face arrière 2B de la cellule, opposée à sa face avant 2A dotée d'une surface réceptrice 3 de lumière. La surface réceptrice de lumière est ainsi dépourvue de contact aux zones dopées.

Généralement, pour former un module photovoltaïque capable de produire de l'énergie électrique selon un courant et une tension donnés, on assemble et on connecte entre elles plusieurs cellules solaires pour réaliser une chaîne de cellules, voire plusieurs chaines de cellules.

Un assemblage conventionnel de cellules solaires à contact en face arrière (RCC) est illustré sur la figure 2 et prévoit de connecter entre elles des cellules 1₁, 1₂, 1₃ par le biais de rubans métalliques d'interconnexion 9 généralement formés par soudure et reliant une électrode négative 8a disposée en face arrière 2B d'une cellule 1₁, 1₂ et une électrode positive 8b disposée en face arrière d'une autre cellule 1₂, 1₃.

Dans certains cas, en particulier pour des chaines importantes de cellules, un tel assemblage peut s'avérer long à réaliser et peut manquer de robustesse.

Il se pose le problème de réaliser un assemblage amélioré de cellules à contact en face arrière.

### EXPOSÉ DE L'INVENTION

Un mode de réalisation de la présente invention concerne une structure assemblée ou comportant un assemblage d'un ensemble de cellules photovoltaïques à contacts en face arrière, les cellules à contacts en face arrière dudit ensemble ayant chacune :
- une face avant munie d'au moins une région centrale avantageusement sans contact ou élément conducteur et destinée à être exposée au soleil,
- une face arrière, opposée à la face avant, et comportant une zone centrale agencée en regard de la région centrale de la face avant, la zone centrale comportant un ou plusieurs premiers contacts agencés respectivement sur une ou plusieurs premières régions dopées selon un dopage de type N, et un ou plusieurs deuxièmes contacts agencés respectivement sur une ou plusieurs deuxièmes régions dopées selon un dopage de type P,
ledit ensemble comprenant une première cellule connectée à une deuxième cellule dudit ensemble, ladite deuxième cellule étant agencée de sorte qu'une zone périphérique de la face arrière de la deuxième cellule chevauche une région périphérique de la face avant de la première cellule, la première cellule et la deuxième cellule étant interconnectées de sorte qu'un premier élément conducteur situé au niveau de ladite région périphérique de ladite première cellule est connecté à et est en contact avec un deuxième élément conducteur de ladite zone périphérique de ladite deuxième cellule, la première cellule étant pourvue en outre d'au moins un élément de connexion reliant le premier élément conducteur à un autre élément conducteur situé sur une portion périphérique de la face arrière de la première cellule.

Par « chevauche », on entend que la zone périphérique de la face arrière de la cellule arrière se superpose en partie à une région périphérique de la face avant de la première cellule.

Typiquement, lorsque le premier élément conducteur est relié électriquement à au moins un desdits premiers contacts ou à une électrode reliée électriquement à au moins un desdits premiers contacts, le deuxième élément conducteur est relié électriquement à au moins un desdits deuxièmes contacts ou à une électrode reliée électriquement à au moins un desdits deuxièmes contacts. Une polarité opposée pour laquelle le premier élément conducteur est relié à au moins un desdits deuxième contacts ou à une électrode reliée à au moins un desdits deuxième contacts, tandis que le deuxième élément conducteur est relié à au moins un desdits premiers contacts ou à une électrode reliée à au moins un desdits premiers contacts peut être également prévue.

Un tel agencement permet d'optimiser la surface active de l'assemblage et présente un encombrement réduit. Un tel agencement a également pour avantage de permettre la mise en oeuvre d'un assemblage robuste. Il permet également de mettre en oeuvre un module photovoltaïque de rendement amélioré. Un tel agencement permet en outre un montage plus aisé et plus rapide de la structure assemblée de cellules.

Dans toute la description qui suit lorsqu'on utilise l'expression « éléments conducteurs », on fait référence à des éléments conducteurs électriquement. On utilise également les termes et expressions « contacts » et « élément de connexion » pour faire référence respectivement à des contacts électriques et des éléments de connexion électriques. De même, « connecté à » et « interconnexion font référence à des connexions ou interconnexions électriques

Selon une première possibilité de mise en oeuvre, l'élément de connexion peut comporter ou être sous forme d'au moins un via conducteur traversant l'épaisseur de ladite première cellule.

Selon une deuxième possibilité de mise en oeuvre, l'élément de connexion comporte une bande conductrice qui s'étend sur un bord latéral de la première cellule reliant la face arrière et la face avant de la première cellule.

Avantageusement l'assemblage peut être doté d'une troisième cellule à contacts en face arrière, la deuxième cellule et la troisième cellule étant interconnectées et se chevauchant partiellement, la structure assemblée étant agencée de sorte qu'une autre zone périphérique de la face arrière de la deuxième cellule chevauche une région périphérique de la face avant de la troisième cellule.

Selon une possibilité l'assemblage peut comporter une autre cellule, ladite autre cellule étant connectée et chevauchant partiellement la première cellule ou la troisième cellule, l'assemblage étant agencé de sorte qu'une zone périphérique de la face arrière de ladite autre cellule est en contact avec une autre région périphérique de la face avant de la première cellule, ou avec une autre région périphérique de la face avant de la troisième cellule.

On peut réaliser ainsi un assemblage avec des cellules située dans un premier plan et des cellules situées dans un deuxième plan distinct du premier plan.

Un mode de réalisation avantageux de la structure prévoit que dans une direction donnée parallèle à un plan principal de la première cellule et de la deuxième cellule, la première cellule a une première largeur Wb et la deuxième cellule a une deuxième largeur Wa, telle que Wb>Wa, le chevauchement étant réalisé de sorte que entre la zone périphérique de la face arrière de la deuxième cellule et la région périphérique de la face avant de la première cellule, la première cellule et la deuxième cellule ont des régions centrales respectives destinées à être exposée au soleil de même surface.

Un mode de réalisation particulier prévoit que lesdites cellules à contacts en face arrière dudit ensemble sont des cellules solaires de type IBC, les premiers contacts et les deuxièmes contacts étant interdigités.

Selon un autre aspect, la présente invention concerne un module photovoltaïque comprenant une structure assemblée telle que définie plus haut.

La présente invention concerne également un procédé de réalisation d'une structure assemblée de cellules telle que définie plus haut.

Un mode de réalisation prévoit un procédé de réalisation d'une structure assemblée de cellules photovoltaïques telles que définies plus haut, le procédé comprenant au moins une étape de découpe en plusieurs portions d'un support doté de plusieurs cellules à contacts en face arrière, ledit au moins un support ayant une face supérieure sur laquelle les faces avant respectives d'une pluralité de cellules à contacts en face arrière sont agencées, et une face inférieure sur laquelle les faces arrière respectives des cellules de ladite pluralité de cellules à contacts en face arrière sont agencées.

Avantageusement ladite première cellule et ladite deuxième cellule peuvent résulter d'une découpe en plusieurs portions d'un même support.

Selon une possibilité de mise en oeuvre, l'étape de découpe dudit support peut être effectuée en différentes portions de surfaces différentes correspondant respectivement à des cellules de ladite pluralité de cellules ayant des faces avant de surfaces différentes.

Avantageusement, la découpe dudit au moins un support peut être réalisée en au moins deux portions ayant une première surface ainsi qu'en au moins deux autres portions ayant une deuxième surface inférieure à la première surface.

La structure assemblée définie plus haut peut avantageusement résulter d'au moins une étape d'assemblage entre la première cellule, la deuxième cellule et au moins une troisième cellule, l'étape d'assemblage comprenant des étapes consistant à :
a) disposer la première cellule et la deuxième cellule sur une surface d'accueil et selon un écartement déterminé, puis
b) disposer une zone périphérique de la deuxième cellule sur des régions périphériques respectivement de la première cellule et de la deuxième cellule.

Un tel mode d'assemblage a pour avantage d'être rapide à mettre en oeuvre et de permettre l'assemblage d'un nombre important de cellules tout en réalisant un gain de temps par rapport à un assemblage conventionnel réalisé à l'aide de rubans métalliques reliant deux à deux les faces arrières de cellules PV.

Avantageusement, à l'étape b) on dispose concomitamment une zone périphérique d'une face arrière d'une autre cellule sur une autre région périphérique de la première cellule ou de la troisième cellule. Cela peut permettre la réalisation d'un assemblage simultané d'un nombre important de cellules.

La première cellule et/ou la deuxième cellule peuvent résulter de la découpe en plusieurs portions d'un même support.

Après découpe dudit support en plusieurs portions et préalablement à l'assemblage, on peut avantageusement former au moins une bande conductrice sur au moins un bord latéral de la dite première cellule et/ou sur au moins un bord latéral de ladite deuxième cellule.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
La figure 1 sert à illustrer un exemple de cellule solaire de type à contacts en face arrière ;
La figure 2 sert à illustrer un exemple d'assemblage conventionnel de cellules solaires à contacts en face arrière ;
Les figures 3A-3B servent à illustrer un exemple d'assemblage de cellules solaires suivant un mode de réalisation de la présente invention, suivant une technique d'interconnexion de type, selon la terminologie anglo-saxonne, appelée « shingle », les cellules étant à contacts en face arrière ;
Les figures 4A-4B et 5A-5B servent à illustrer différentes structures de connexion permettant de relier électriquement la face avant et la face arrière de cellules solaires dans un assemblage tel que mis en oeuvre suivant l'invention ;
Les figures 6A-6B et 7A-7B servent à illustrer un exemple de structure assemblée doté d'au moins trois cellules solaires avec un agencement amélioré permettant de réaliser rapidement l'assemblage ;
Les figures 8A-8B servent à illustrer un assemblage avec une pluralité de cellules solaires réparties dans un même plan et une pluralité d'autres cellules solaires réparties dans un même autre plan ;
Les figures 9A-9B servent à illustrer une répartition de contacts et éléments conducteurs respectivement sur les faces arrière et avant d'une cellule solaire de type IBC susceptible d'être intégrée à un assemblage tel que mis en oeuvre suivant l'invention ;
Les figures 10A-10B servent à illustrer un assemblage avec des cellules de dimensions différentes mais susceptibles d'avoir une même surface active exposée au soleil ;
La figure 11 sert à illustrer une étape de découpe en cellules élémentaires d'un support comportant plusieurs cellules solaires élémentaires au moins partiellement formées, en particulier de type IBC ;
Les figures 12 et 13A-13B servent à illustrer une étape de découpe d'un support comportant plusieurs cellules solaires au moins partiellement formées, en cellules élémentaires de dimensions différentes ;
Les figures 14A-14C servent à illustrer une étape de découpe d'un support pour former des cellules solaires de type IBC ;
Les figures 15A-15D servent à illustrer une réalisation d'éléments de connexion entre face avant et face arrière d'une cellule solaire de type IBC puis un assemblage sur deux plans de plusieurs cellules de même type ;
Les figures 16A-16D servent à illustrer différentes configurations sur la face avant ou la face arrière d'une cellule solaire d'éléments de connexion permettant de relier la face avant et face arrière de cette cellule solaire ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « avant », « supérieure », « arrière », « inférieure », « latérale », « centrale », « périphérique » s'appliquent en considérant que la structure est orientée de la façon illustrée sur les figures.

### EXPOSÉ DÉTAILLÉ DE MODES DE RÉALISATION PARTICULIERS

On se réfère à présent à la figure 3 donnant un exemple d'assemblage de cellules solaires 10₁, 10₂ de type à contact en face arrière RCC.

Les cellules solaires 10₁, 10₂, sont formées à partir d'un substrat semiconducteur, qui peut être poly ou mono-cristallin et en particulier à base de silicium polycristallin ou monocristallin. Chacune des cellules est dotée d'une face 2A avant réceptrice de lumière et qui est destinée à être exposée au rayonnement solaire R et d'une face arrière 2B opposée à la face avant 2A.

Les cellules solaires 10₁, 10₂, de cet assemblage sont comme dans l'exemple de réalisation de la figure 1, avec des contacts répartis essentiellement sur la face arrière 2B, dont un ou plusieurs contacts (non représentés sur cette figure) à respectivement une ou plusieurs zones dopées de type N (autrement dit ayant un dopage produisant un excès d'électrons) et un ou plusieurs contacts (non représentés sur cette figure) à respectivement une ou plusieurs zones dopées de type P (autrement dit selon un dopage consistant à produire un déficit d'électrons), la ou les zones de type N associé(es) à la ou les zones de type P formant au moins une jonction.

Les contacts aux zones dopées répartis principalement du côté de la face arrière 2B des cellules 10₁, 10₂, s'étendent notamment sur une zone centrale 21B de la face arrière 2B. En regard de cette zone centrale 21B, on prévoit une région centrale 21A de la face avant 2A sans contact, cette région centrale 21B pouvant être recouverte par exemple d'une couche de passivation.

Les contacts sont reliés respectivement à, ou forment, au moins une électrode dite « négative » et à au moins une électrode dite « positive » suivant qu'ils sont situés sur une zone dopée de type N ou P.

L'assemblage est tel qu'une région périphérique 22A (dans l'exemple illustré correspondant à un bord droit supérieur) située sur la face avant 2A et à l'extérieur de la région centrale 21A d'une première cellule 10₁ est disposée contre une zone périphérique 23B (dans l'exemple illustré un bord gauche inférieur) de la face arrière 2B d'une deuxième cellule 10₂.

Les cellules solaires 10₁, 10₂, sont ici assemblées de sorte à se chevaucher ce qui permet notamment de réaliser un montage compact.

Outre l'assemblage, la connexion des cellules entre elles est réalisée typiquement en série de manière à relier une électrode 13n négative d'une cellule 10₁ à une électrode 13p positive d'une autre cellule 10₂.

Pour cela, un élément conducteur 12 au niveau de la région périphérique 22A de la face avant 2A de la première cellule 10₁ est connecté à une électrode 13p, dans cet exemple positive, de ladite zone périphérique 23B située en face arrière 2B de ladite deuxième cellule 10₂.

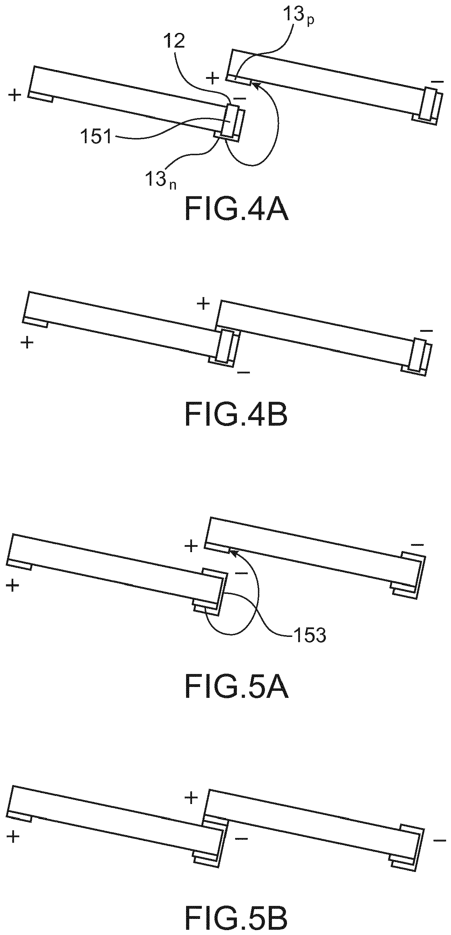

Pour permettre de relier l'élément conducteur 12 à l'électrode 13n, dans cet exemple négative, située sur la face 2B opposée de la première cellule 10₁, on peut prévoir, comme dans l'exemple de mise en connexion illustré sur les figures 4A-4B, un élément de connexion traversant, sous forme d'un via ou comprenant un via conducteur 151 réalisé dans l'épaisseur de la cellule. Le via conducteur 151 s'étend ainsi de la face arrière 2B à la face avant 2A de la cellule.

Alternativement (figures 5A-5B), l'élément de mise en connexion entre élément conducteur 12 et électrode 13n peut être sous forme ou comprendre une bande conductrice 153 qui s'étend sur un bord latéral de la cellule et relie la face arrière 2B et la face avant 2A de la cellule.

Afin de réaliser un module photovoltaïque on prévoit typiquement de mettre en oeuvre un assemblage et une interconnexion d'un nombre de cellules plus important.

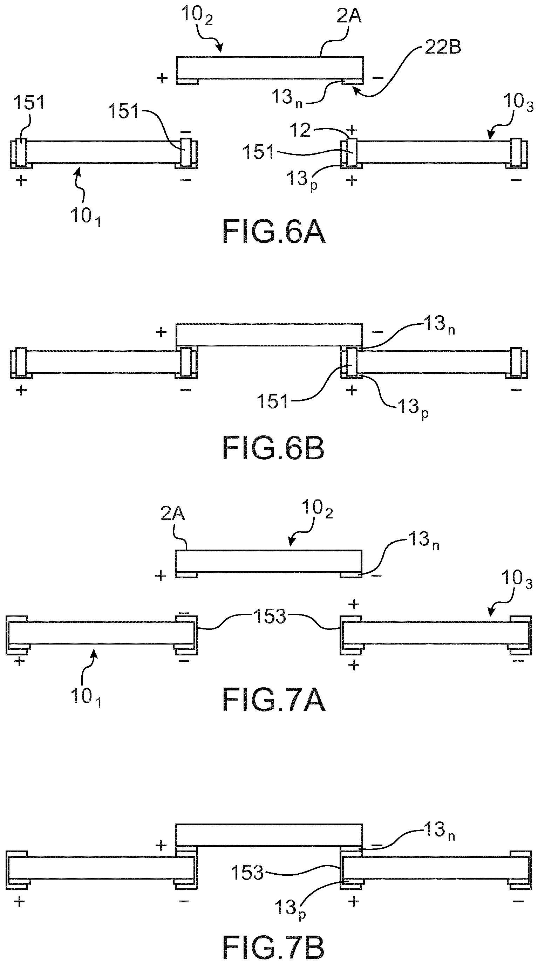

Dans les exemples de réalisation des figures 6A-6B, et 7A-7B, une troisième cellule 10₃ est agencée de sorte qu'une zone périphérique 22B (dans l'exemple illustré un bord droit inférieur) de la face arrière 2B de la deuxième cellule 10₂ est mise en contact avec une région périphérique 23A (dans l'exemple illustré un bord droit supérieur) de la face avant 2A de la troisième cellule 10₃.

Outre la manière dont elles sont assemblées, la connexion des cellules 10₂, 10₃ entre elles, est réalisée typiquement de manière à relier une électrode 13p, par exemple positive, de la troisième cellule 10₃ à une électrode 13n, ici négative, de la deuxième cellule 10₂.

Pour cela, un élément conducteur 12 au niveau d'une région périphérique 23A de la face avant 2A de la troisième cellule 10₃ est mis en contact avec l'électrode 13p de la zone périphérique 22B située en face arrière 2B de ladite deuxième cellule 10₂. L'élément conducteur 12 est lui-même relié à l'électrode 13p située sur la face arrière 2B de la troisième cellule 10₃ à l'aide d'un élément de connexion doté d'un via conducteur 151 traversant la troisième cellule 10₃ (figures 6A-6B) ou d'une bande conductrice recouvrant un bord de la troisième cellule 10₃ (figures 7A-7B).

Pour réaliser un tel type d'assemblage entre des cellules 10₁, 10₂, 10₃, on dispose typiquement les première et troisième cellules 10₁, 10₃ sur une surface d'accueil S et selon un écartement déterminé, puis on accole des bords inférieurs de la face arrière de la deuxième cellule 10₂ sur des régions périphériques respectivement de la première cellule et de la deuxième cellule. Un tel type de montage a pour avantage d'être rapide à mettre en oeuvre. La deuxième cellule 10₂ située au-dessus des autres cellules 10₁, 10₃, est dans dépourvue de contact sur sa face avant 2A et peut même être dépourvue d'élément conducteur sur sa face avant.

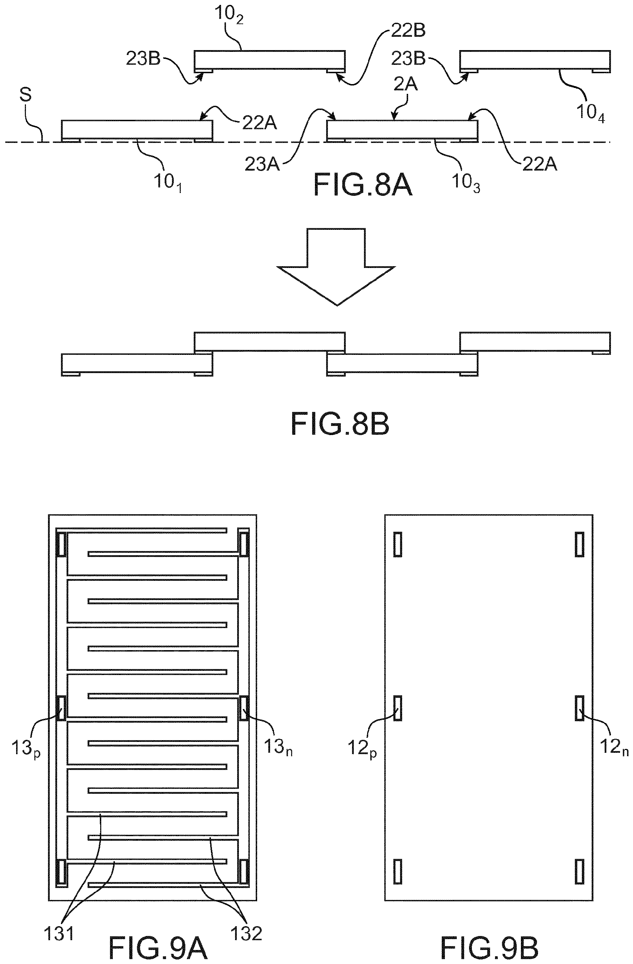

Dans l'exemple d'assemblage illustré sur les figures 8A-8B, une quatrième cellule 10₄ à contacts par la face arrière est agencée en faisant se chevaucher une zone périphérique 23B (ici le bord gauche inférieur) de sa face arrière 2B avec une zone périphérique 22A (ici le bord droit supérieur) de la face avant 2A de la troisième cellule 10₃.

Selon un aspect avantageux, un tel montage permet de disposer simultanément plusieurs cellules solaires 10₂, 10₄ respectivement sur les cellules 10₁, 10₃ agencés sur la surface d'accueil. On peut ainsi réduire la durée de fabrication d'un module solaire susceptible de comporter un nombre de cellules supérieur à 4. Un exemple de réalisation particulier de module comporte un assemblage de 72 cellules.

On obtient dans l'exemple illustré sur les figures 8A-8B un assemblage avec plusieurs cellules solaires 10₂, 10₄ situées dans un même plan dit « supérieur » et plusieurs cellules solaires 10₁, 10₃ situées dans un même plan dit « inférieur ». Les cellules 10₂, 10₄ situées au niveau supérieur sont avantageusement dépourvues de contact ou d'élément conducteur sur leur face avant 2A. Cette répartition sur deux plans permet également de limiter l'encombrement en hauteur du montage.

L'un ou l'autre des assemblages décrits précédemment peut être réalisé en particulier à l'aide des cellules à contact en face arrière de type IBC (IBC pour « Interdigitated Back Contact »), dont un exemple d'agencement des faces arrière et avant est donné respectivement sur les figures 9A, 9B.

En face arrière (figure 9A) d'une telle cellule IBC, les contacts 131, 132, aux zones semi-conductrices dopées de type opposés P et N sont sous forme de doigts métalliques interdigités.

Une ou plusieurs zones d'électrodes 13p positives sont disposées en contact de doigts 131 eux-mêmes en contact d'au moins une zone de type P. Une ou plusieurs zones d'électrodes 13n négatives sont disposées en contact de doigts 132 eux-mêmes en contact d'au moins une zone de type N.

En face avant (figure 9B) de la cellule IBC, des éléments conducteurs 12p, 12n reliés respectivement aux électrodes positive 13p et négative 13n sont agencés sur des régions périphériques, à proximité des bords de la face avant. Une région centrale de superficie supérieure aux régions périphériques est quant à elle dépourvue d'élément conducteur ou de contact.

Dans l'un ou l'autre des exemples d'agencements décrits précédemment, une cellule située dans un plan dit « supérieur » empiète partiellement sur une face avant d'une cellule située dans un plan dit « inférieur ».

Aussi, notamment pour permettre une production d'énergie électrique uniforme d'une cellule à l'autre on peut prévoir un agencement particulier avec des cellules de tailles différentes, agencées de sorte à avoir des zones sensibles exposées au soleil de surfaces identiques ou sensiblement identiques. Par « sensiblement » on entend tout au long de la description qui diffère de moins de 1 %.

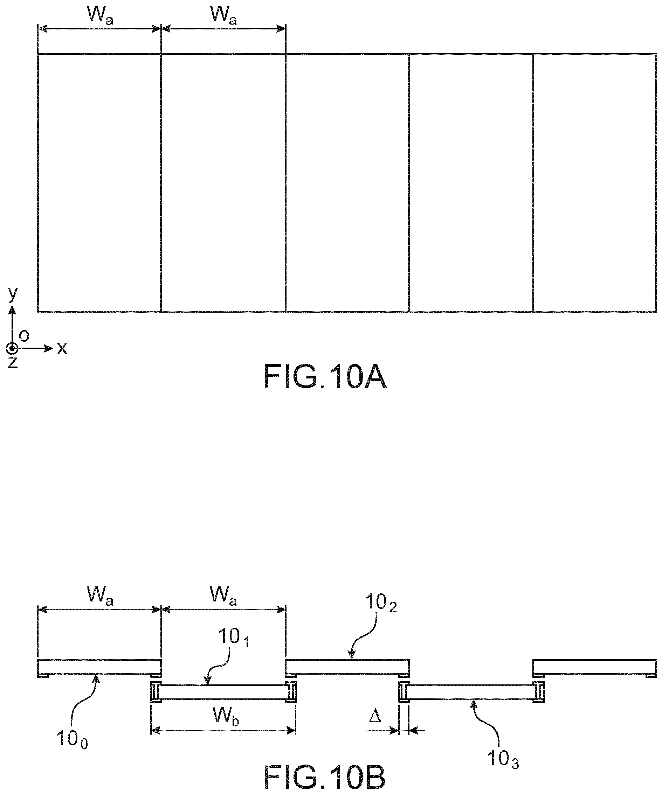

Un exemple de réalisation d'un tel agencement est donné sur les figures 10A-10B représentatives respectivement d'une vue de dessus et d'une vue en coupe transversale.

Dans une direction donnée parallèle à un axe x (axe d'un repère orthogonal [O ;x ;y ;z]), des cellules 10o, 10₂, 10₄ situées dans un même plan supérieur ont une largeur Wa plus faible que la largeur Wb de cellules 10₁, 10₃, situées dans un même plan inférieur et sur lesquelles les cellules 10₀, 10₂, 10₄ empiètent partiellement.

Le chevauchement entre la zone périphérique de la face arrière des cellules 10o, 10₂, 10₄ du plan supérieur, et la région périphérique de la face avant des cellules 10₁, 10₃, du plan inférieur est prévu avantageusement de sorte que les cellules 10₀, 10₂, 10₄ de niveau supérieur et les cellules 10₁, 10₃, de niveau inférieur ont des régions centrales respectives destinées à être exposée au soleil de même surface ou sensiblement de même surface.

Dans l'exemple illustré, les cellules 10₁, 10₃, de niveau inférieur ont en particulier des régions centrales visibles et non empiétées (autrement dit non recouvertes) de largeur Wa égale ou sensiblement égale à celle des cellules 10₀, 10₂, 10₄ de niveau supérieur. Dans un tel montage, la longueur de chevauchement Δ entre une cellule et sa cellule voisine peut être prévue par exemple telle que Δ= (Wb-Wa)/2.

Les cellules d'un assemblage tel que décrit précédemment sont formées à partir d'un substrat qui peut lui-même résulter de la découpe d'un support ou d'un substrat en plusieurs parties ou portions.

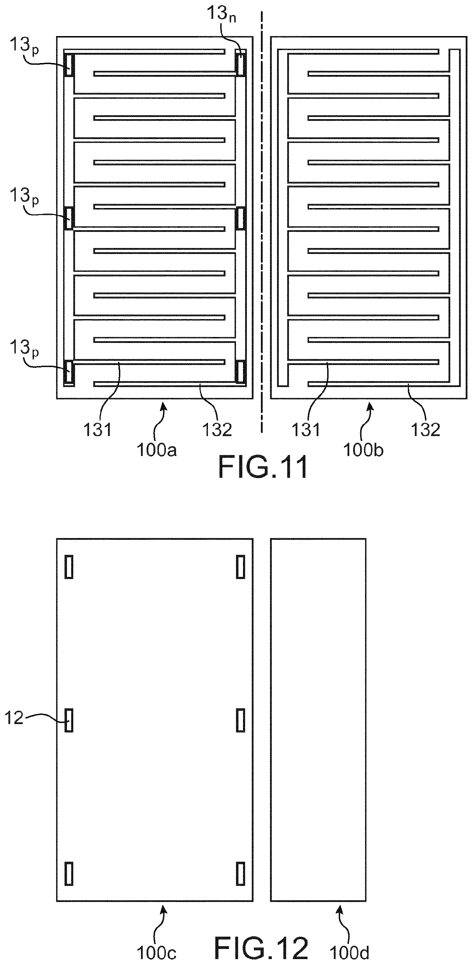

Dans l'exemple de réalisation illustré sur la figure 11, une face inférieure d'un support comportant les faces arrière 2B respectives de cellules à contacts 131, 132 en face arrière est découpée en deux portions 100a, 100b, chaque portion étant susceptible de former une cellule élémentaire. Une telle découpe est réalisée par exemple à l'aide d'un laser. Dans cet exemple, les électrodes et contacts en face arrière sont réalisés préalablement à l'étape de découpe, par exemple par sérigraphie, les électrodes et contacts pouvant être déposés par exemple sous forme d'une pate conductrice.

Dans l'exemple de réalisation illustré sur la figure 12, on prévoit une découpe d'une face supérieure d'un support différent comportant les faces avant 2A respectives de plusieurs cellules en plusieurs portions 100c, 100d. Chaque portion est susceptible de former une cellule élémentaire. Un ou plusieurs éléments conducteurs 12 émergeant en face avant sont réalisés préalablement à la découpe sur des régions périphériques ou bords périphériques de la face avant.

Après cette découpe on effectue ensuite l'assemblage en apposant typiquement un élément conducteur 12 de la face avant d'une portion 100c ou cellule élémentaire découpée sur une électrode 13p ou 13n de la face arrière d'une autre portion 10 ou cellule élémentaire découpée.

Une autre portion 100d totalement dépourvue de contact ou d'élément conducteur sur sa face avant peut être également utilisée en vue d'un montage avec une autre portion formant une cellule élémentaire.

Les éléments de connexion permettant de relier électriquement la face avant et la face arrière et sous forme par exemple d'une ou plusieurs bandes conductrices sur des bords latéraux ou sous forme de vias conducteurs peuvent être réalisés après l'étape de découpe.

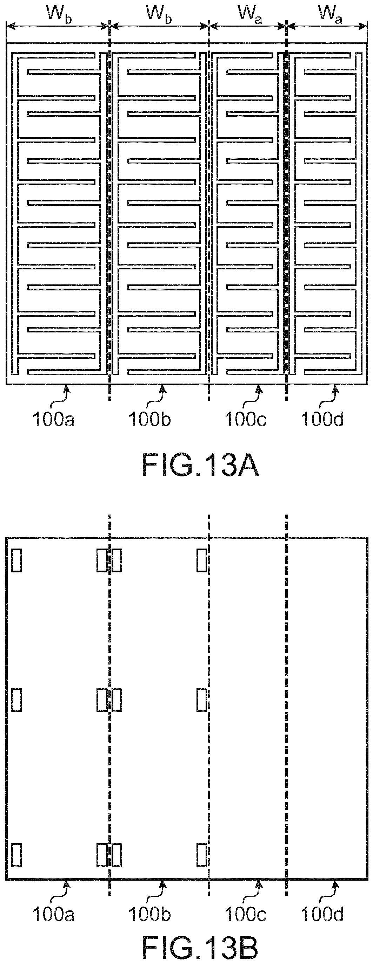

Dans l'exemple de réalisation des figures 13A-13B, une face inférieure (figure 13A) et une face supérieure (figure 13B) d'un support destiné à former plusieurs cellules élémentaires de largeurs différentes Wb, Wa sont représentées préalablement à une découpe du support en plus de deux portions élémentaires 100a, 100b, 100c, 100d.

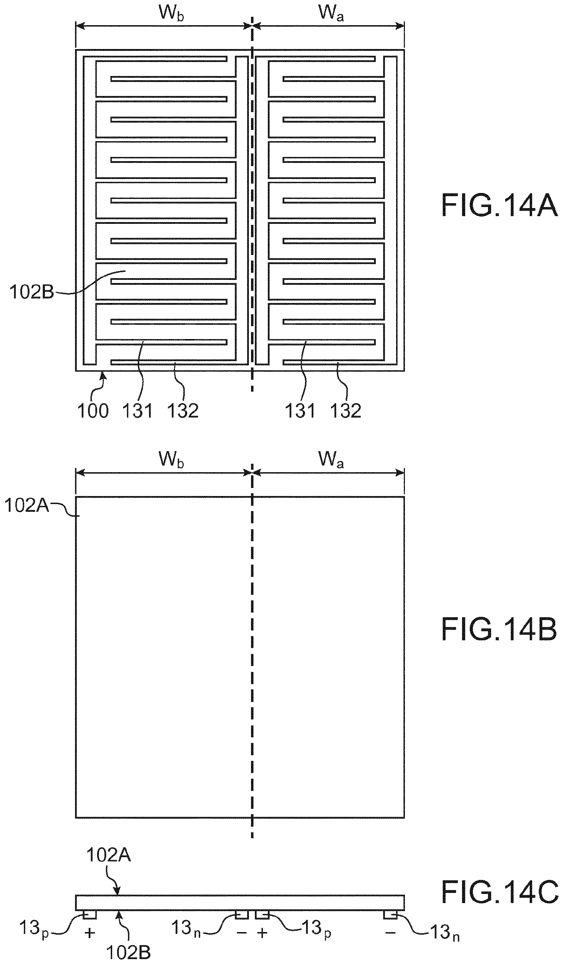

Dans l'exemple de réalisation des figures 14A-14C (donnant respectivement une vue de dessous, une vue de dessus et une vue en coupe transversale), pour former des cellules élémentaires, on prévoit de découper un support 100 en portions ou cellules élémentaires de largeurs Wb, Wa différentes. Seule la face inférieure (102B, figure 14A) du support est dotée de contacts 131, 132 et/ou d'électrodes 13p, 13n. La face supérieure (102A, figure 14B) est quant à elle sans contact ou électrode, voire même sans élément conducteur.

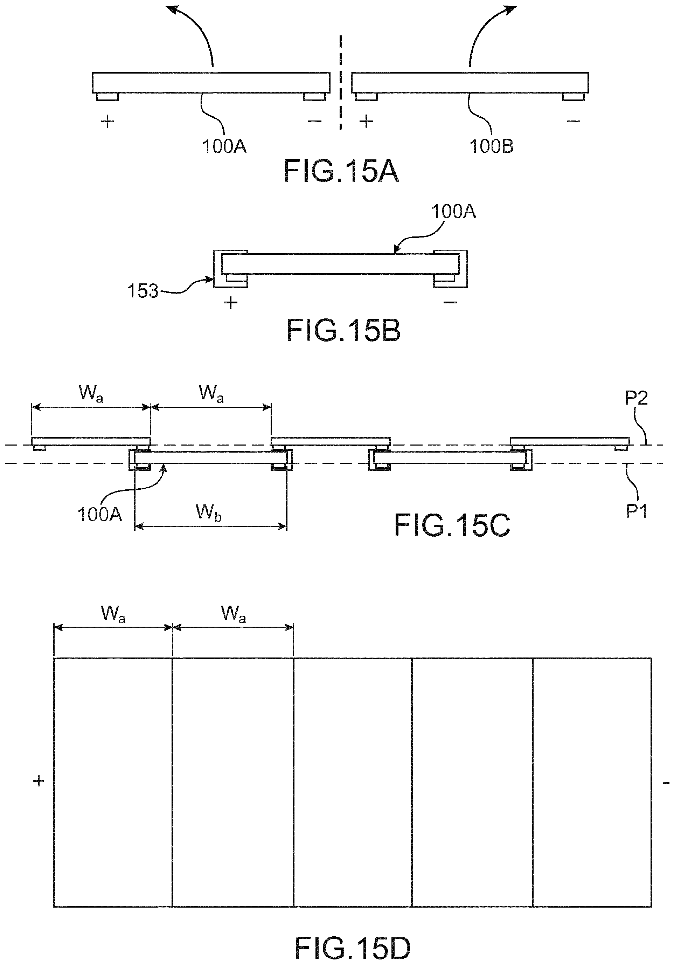

Un exemple de procédé de fabrication d'un module solaire comprend, une fois la découpe du support 100 en plusieurs cellules élémentaires 100A, 100B effectuée (figure 15A), une étape de réalisation d'éléments de connexion qui permettent de relier électriquement la face arrière et la face avant de la cellule. Les éléments de connexion sont ici dotés de bandes conductrices 153 qui s'étendent sur les bords latéraux d'une cellule élémentaire 100B et empiètent sur la face avant et la face arrière de la cellule. Ces bandes conductrices sont réalisées par exemple par sérigraphie.

La cellule élémentaire 100B est ensuite assemblée à d'autres cellules solaires. L'assemblage des cellules peut se fait par soudure ou de préférence par collage, en particulier au moyen d'une colle conductrice.

Dans l'exemple d'assemblage de la figure 15C, on prévoit en particulier d'assembler la cellule élémentaire 100B à d'autres cellules élémentaires 100A issues du même support. L'assemblage final comporte un premier plan P1 ou plan inférieur de cellules, et un deuxième plan P2 ou plan supérieur, chacun doté d'une pluralité de cellules solaires. Les cellules du deuxième plan P2 ont ici une largeur Wa plus faible que celle Wb des cellules du premier plan P1, tandis que l'assemblage vu de dessus (figure 15D) comporte des régions destinées à être exposées au soleil, de même largeur Wa.

Les éléments de connexion permettant de relier liaison électriquement la face avant et la face arrière peuvent prendre différentes formes.

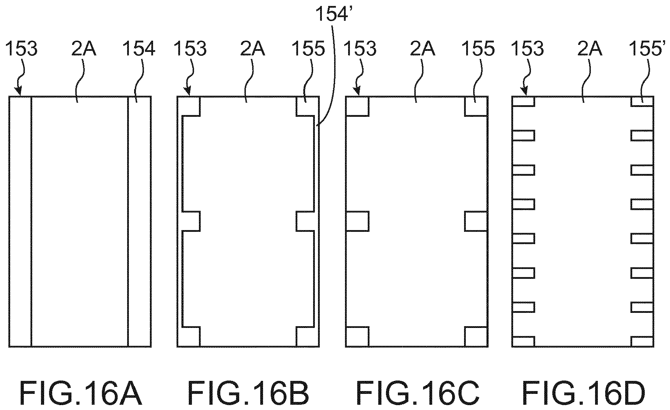

Sur les figures 16A-16D, ce sont différentes formes d'éléments de connexion dotés chacun de bande conductrices latérales qui sont représentées. Outre la bande conductrice latérale qui s'étend sur la tranche ou sur le flanc latéral d'une cellule entre sa face avant 2A (montrée sur ces figures) et sa face arrière (non visible sur ces figures), les éléments de connexion s'étendent sur la face avant et sur la face arrière sous forme de zones conductrices qui peuvent avoir des configurations diverses.

Par exemple, dans l'exemple de la figure 16A, ces zones conductrices sont des bandes conductrices 154 disposées dans la région périphérique de la face avant ou dans la zone périphérique de la face arrière et qui s'étendent sur toute la longueur de la cellule. Dans l'exemple de réalisation de la figure 16B, ces zones conductrices sont des sous forme de plots 155 disposés en région périphérique de la face avant ou en zone périphérique de la face arrière et reliés entre eux par des bandes conductrice 154' de largeur plus faible.

En variante, on peut prévoir comme dans l'exemple de la figure 16C, de prolonger les bandes conductrices latérales par des plots conducteurs 155 distincts disposés en région périphérique de la face avant ou en zone périphérique de la face arrière.

Dans l'exemple de la figure 16D, on prévoit des plots conducteurs 155' de plus petite taille répartis en région périphérique de la face avant ou en zone périphérique de la face arrière à proximité des bords latéraux longitudinaux d'une cellule. La forme de ces zones conductrices peut être adaptée en fonction du compromis que l'on souhaite réaliser entre les performances électriques en termes de résistance et de facilité du montage.

## Revendications

1. Structure comportant un assemblage d'un ensemble de cellules photovoltaïques à contacts en face arrière, les cellules à contacts en face arrière dudit ensemble ayant chacune :
- une face avant (2A) munie d'au moins une région centrale (21A) sans contact destinée à être exposée au soleil,
- une face arrière (2B), opposée à la face avant, et comportant une zone centrale (21B) agencée en regard de la région centrale de la face avant, la zone centrale comportant un ou plusieurs premiers contacts (131) agencés respectivement sur une ou plusieurs premières régions dopées selon un dopage de type N, et un ou plusieurs deuxièmes contacts (132) agencés respectivement sur une ou plusieurs deuxièmes régions dopées selon un dopage de type P,
ledit ensemble comprenant une première cellule (10₁) connectée à une deuxième cellule (10₂) dudit ensemble, ladite deuxième cellule étant agencée de sorte qu'une zone périphérique de la face arrière de la deuxième cellule chevauche une région périphérique de la face avant de la première cellule,
la première cellule et la deuxième cellule étant interconnectées de sorte qu'un premier élément conducteur (22A) au niveau de ladite région périphérique de ladite première cellule est connecté à et est en contact avec un deuxième élément conducteur (23B) de ladite zone périphérique de ladite deuxième cellule,
la première cellule étant pourvue en outre d'au moins un élément de connexion (151, 153) reliant le premier élément conducteur (22A) à un autre élément conducteur (13B) situé sur une portion périphérique de la face arrière de la première cellule (10₁),
dans une direction donnée parallèle à un plan principal de la première cellule et de la deuxième cellule, la première cellule a une première largeur Wb et la deuxième cellule a une deuxième largeur Wa, telle que Wb>Wa, le chevauchement entre la zone périphérique de la face arrière de la deuxième cellule et la région périphérique de la face avant de la première cellule étant prévu de sorte que la première cellule et la deuxième cellule ont des régions centrales respectives destinée à être exposée au soleil de même surface.

2. Structure selon la revendication 1, dans lequel l'élément de connexion comporte un via conducteur (151) traversant l'épaisseur de la première cellule.

3. Structure selon la revendication 1, dans lequel l'élément de connexion comporte une bande conductrice (153) qui s'étend sur un bord latéral de la première cellule et relie la face arrière et la face avant de première cellule (10₁).

4. Structure selon l'une des revendications 1 à 3, dans lequel l'assemblage comporte une troisième cellule (10₃) à contacts en face arrière, la deuxième cellule (10₂) et la troisième cellule étant interconnectées et se chevauchant partiellement, la structure assemblée étant agencée de sorte qu'une autre zone périphérique de la face arrière de la deuxième cellule chevauche une région périphérique de la face avant de la troisième cellule.

5. Structure selon l'une des revendications 1 à 4, dans lequel l'assemblage comporte une autre cellule (10₀, 10₄), ladite autre cellule étant connectée et chevauchant partiellement la première cellule (10₁) l'assemblage étant agencé de sorte qu'une zone périphérique de la face arrière de ladite autre cellule est en contact avec une autre région périphérique de la face avant de la première cellule,
ou lorsque l'assemblage comporte une troisième cellule, ladite autre cellule étant connectée et chevauchant partiellement la troisième cellule (10₃), l'assemblage étant agencé de sorte qu'une zone périphérique de la face arrière de ladite autre cellule est en contact avec une autre région périphérique de la face avant de la troisième cellule.

6. Structure selon l'une des revendications 1 à 5, dans lequel lesdites cellules (10₀, 10₁, 10₂, 10₃, 10₄) à contacts en face arrière dudit ensemble sont de type IBC, les premiers contacts et les deuxièmes contacts étant interdigités.

7. Module photovoltaïque comprenant une structure selon l'une des revendications 1 à 6.

8. Procédé de réalisation d'une structure selon l'une des revendications 1 à 6, comprenant au moins une étape de découpe en plusieurs portions d'un support comportant plusieurs cellules à contacts en face arrière, ledit au moins un support ayant une face supérieure sur laquelle les faces avant respectives d'une pluralité de cellules à contacts en face arrière sont agencées, et une face inférieure sur laquelle les faces arrière respectives des cellules de ladite pluralité de cellules à contacts en face arrière sont agencées.

9. Procédé selon la revendication 8, dans lequel, ladite première cellule (10₁) et ladite deuxième cellule (10₂) résultent de ladite découpe en plusieurs portions dudit support.

10. Procédé selon l'une des revendications 8 ou 9, dans lequel la découpe dudit support est réalisée en différentes portions de surfaces différentes correspondant respectivement à des cellules de ladite pluralité de cellules ayant des faces avant de surfaces différentes.

11. Procédé selon la revendication 10, dans lequel ladite découpe dudit au moins un support est réalisé en au moins deux portions ayant une première surface et ayant au moins deux autres portions ayant une deuxième surface différente inférieure à la première surface.

12. Procédé de réalisation d'une structure selon l'une des revendications 1 à 6, dans lequel la structure assemblée résulte d'au moins une étape d'assemblage entre la première cellule, la deuxième cellule et au moins une troisième cellule, l'étape d'assemblage comprenant :
a) disposer la première cellule et la troisième cellule sur une surface d'accueil et selon un écartement déterminé, puis
b) disposer une zone périphérique de la deuxième cellule sur des régions périphériques respectivement de la première cellule et de la troisième cellule.

13. Procédé selon la revendication 12, dans lequel à l'étape b) on dispose concomitamment une zone périphérique d'une face arrière d'une autre cellule sur une autre région périphérique de la première cellule ou de la troisième cellule.

14. Procédé selon l'une des revendications 12 ou 13, dans lequel ladite première cellule et/ou la deuxième cellule résulte(nt) de ladite découpe en plusieurs portions d'un support et dans lequel après découpe dudit support en plusieurs portions et préalablement à l'assemblage, on forme au moins une bande conductrice sur au moins un bord latéral de la dite première cellule et/ou sur au moins un bord latéral de ladite deuxième cellule.
